(19) Europäisches Patentamt
European Patent Office
Office européen des brevets

(11) Publication number: **0 401 935 A1**

(12) **EUROPEAN PATENT APPLICATION**

(21) Application number: **90201440.6**

(51) Int. Cl.5: **H01L 23/29**

(22) Date of filing: **06.06.90**

(30) Priority: **08.06.89 NL 8901457**

(43) Date of publication of application:
**12.12.90 Bulletin 90/50**

(84) Designated Contracting States:
**AT BE CH DE DK ES FR GB GR IT LI NL SE**

(71) Applicant: **STAMICARBON B.V.**
**Mijnweg 1**
**NL-6167 AC Geleen(NL)**

(72) Inventor: **Claessens, Hubertus Marie**
**Nutherweg 21**
**NL-6365 EP Schinnen(NL)**
Inventor: **Nix, Frederik Ernst**
**Silhof 23**
**NL-6418 JV Heerlen(NL)**
Inventor: **Kingma, Johannes Albert Josephus Maria**
**Mesdagstraat 11**
**NL-6165 VH Geleen(NL)**

(54) **Package made from liquid-crystalline polymer composition.**

(57) The invention relates to a package for an integrated circuit consisting of a carrier and an encapsulating element, the encapsulating element being made from a liquid-crystalline polymer composition, characterized in that the encapsulating element consists of a liquid-crystalline polymer composition moulded round the carrier with an opening for taking up an integrated circuit, the liquid-crystalline polymer in the polymer composition having a maximum pressure flow index (PFI) of 8.5 g/10 minutes. The liquid-crystalline polymer composition comprises:
- 20-70% (wt) units obtained from parahydroxybenzoic acid,
- 5-50% (wt) units obtained from biphenol and/or hydroquinone,
- 5-50% (wt) units obtained from terephtahlic and/or isophthalic acid, and
- 1-60% (wt) of one or more fillers.

Such packages have excellent mechanical properties. No corrosion of the carrier occurs during the moulding process. The packages are particularly suited for the production of custom ICs.

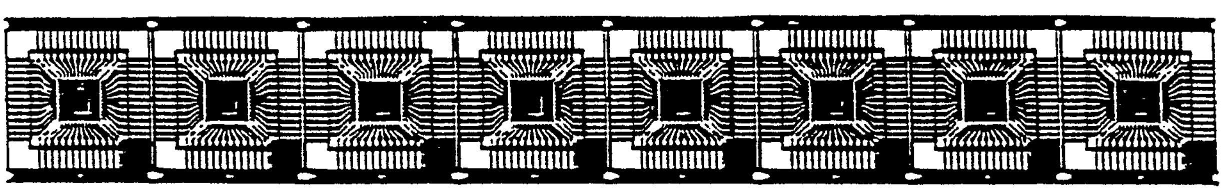

FIG. 1

EP 0 401 935 A1

## PACKAGE MADE FROM LIQUID-CRYSTALLINE POLYMER COMPOSITION

The invention relates to a package for an integrated circuit consisting of a carrier and an encapsulating element, the encapsulating element being made from a liquid-crystalline polymer composition.

Such a package is known from EP-A-135310. In that patent specification packages are described obtained by applying, round an integrated circuit mounted on a carrier, an encapsulating element of a liquid-crystalline polymer composition.

In order to obtain a proper encapsulation of the integrated circuit, the molecular weight of the liquid-crystalline polymer in the composition must be limited. A low molecular weight is necessary to keep the viscosity of the liquid-crystalline polymer composition low in order to obtain reasonable processing characteristics. A disadvantage of the low molecular weight is that the mechanical properties of the ultimately resulting package are insufficient.

The object of the invention is to provide a package of which the encapsulating element is made from a liquid-crystalline polymer composition, with optimum mechanical properties and a minimum risk of damaging the wires on the carrier during the moulding of the package.

This object is achieved in that the encapsulating element consists of a liquid-crystalline polymer composition moulded round the carrier with an opening for taking up the integrated circuit, the liquid-crystalline polymer in the polymer composition having a maximum pressure flow index of 8.5 g/10 minutes.

It has been found that the package obtained according to the invention is highly suited for taking up an integrated circuit, because the mechanical properties have considerably improved. It has also been found that during the moulding of the encapsulating element no contamination of the lead frame takes place. The package according to the invention is highly suited for being made in a continuous process.

It should be noted that pre-moulded packages for integrated circuits are known per se, the so-called preformed packages. A preformed package is a package consisting of an encapsulating element applied to a carrier (lead frame), having an opening for taking up an integrated circuit, which opening can be sealed with a sealer. The encapsulating element is applied to a preformed metal strip serving as carrier. The metal strip has a thickness of a few millimetres at most and is made from, for instance, a copper or an iron/nickle alloy. The encapsulating elements of the current commercially available pre-moulded packages are made of ceramics or of thermosetting materials.

Packages according to the invention have a higher temperature resistance than packages with encapsulating elements made from thermosetting materials. As a result, packages according to the invention can better cope with the various soldering techniques known per se. For instance, fitting a package to a printing board using infrared or vapour phase soldering processes.

It has also been found that the package according to the invention shows a lower $\alpha$-emission than a package having an encapsulating element made from ceramic material. The lower $\alpha$-emission results in a reduced risk of soft-error generation and hence in a better performance of the integrated circuit. A second disadvantage is that ceramic materials must be sintered at high temperatures, which results in the oxidation (corrosion) of the carrier. As sintering is a discontinuous process, ceramic packages cannot be made in a continuous production process. A third disadvantage is the brittleness of ceramic materials, which results in poor mechanical properties.

Liquid-crystalline polymer compositions are known per se. Generally, thermotropic liquid-crystalline polymer compositions consist of polymers with rigid aromatic units. For instance:
units with an oxy and a carboxyl group,
units with two oxy groups, and
units with two carboxyl groups.

Generally, a unit with an oxy and a carboxyl group has a formula

$O\text{-}R\text{-}\overset{O}{C}\text{-}O$, where R contains at least one aromatic ring. For instance:

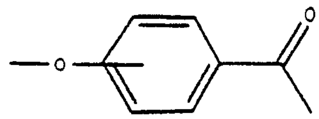

(Ia)

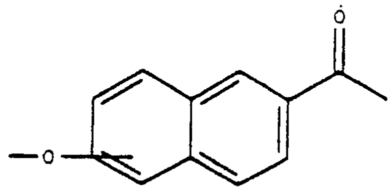

(Ib)

A polymer in the polymer composition preferably comprises oxybenzoyl units having the formula (Ia). These units are obtained from hydroxybenzoic acid or from derivatives thereof. Both the para and the meta-substituted unit may be used. Preferably unit (Ia) is para-substituted. In the aromatic ring one or more hydrogen atoms may be substituted by an alkyl or alkoxy group with one to four carbon atoms, by a halogen, for instance chlorine, bromine and fluorine, and/or by a phenyl group, which may be substituted, if so desired.

Units with two oxy groups generally have a formula O-R-O. Examples are:

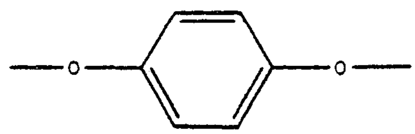

(IIa)

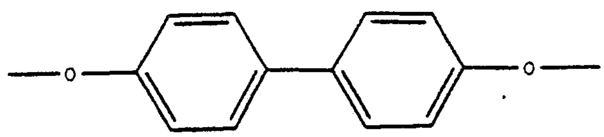

(IIb)

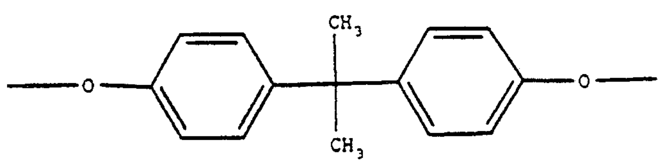

(IIc)

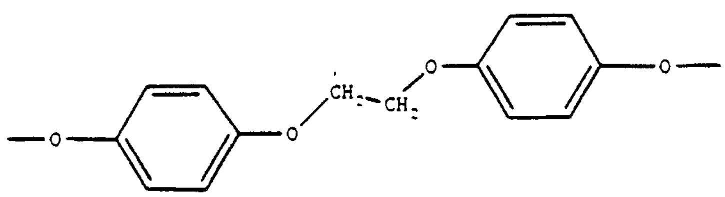

(IId)

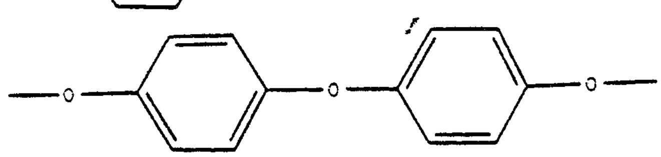

(IIe)

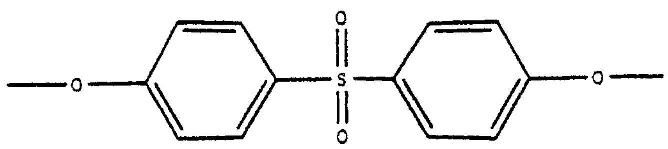

(IIf)

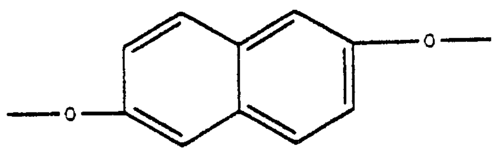

(IIg)

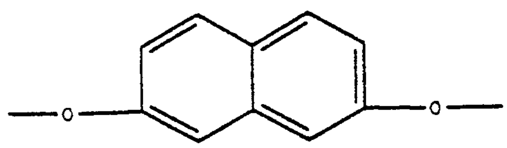

(IIh)

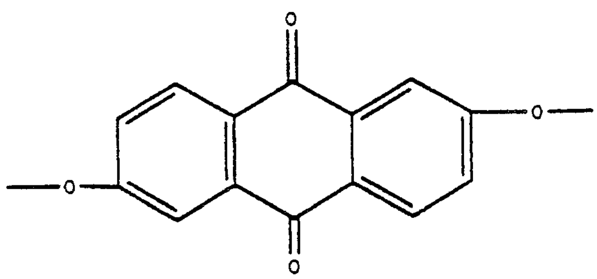

(IIi)

A polymer in the polymer composition may also comprise mixtures of the above-mentioned units. The polymer according to the invention preferably contains dioxyphenyl (IIa) and/or biphenoxy (IIb) groups, more particularly a biphenoxy group with the formula (IIb). The last-mentioned compound can be obtained from p,p′-biphenol. In the aromatic rings one or more hydrogen atoms can be substituted by an alkyl and/or alkoxy group, a halogen and/or a phenyl group, which itself may be substituted, too.

The aromatic units with two carboxyl groups can be obtained from aromatic dicarboxylic acids or from the corresponding esters, for instance terephthalic acid, isophthalic acid, 2,6-naphthalenedicarboxylic acid, 2,7-naphthalenedicarboxylic acid, bibenzoic acid, 4,4′-dicarboxyldiphenylsulphone, 4,4′-dicarboxydiphenylethane, 4,4′-dicarboxydiphenylsulphide, 4,4′-dicarboxydiphenylether, 4,4′-dicarboxydiphenylmethane, 4,4′-dicarboxydiphenoxyethane, 2,2-bis(4-carboxyphenyl)propane.

The aromatic units with two carboxyl groups have preferably been obtained from terephthalic acid, isophthalic acid and/or from the derivatives thereof. In the aromatic ring one or more hydrogen atoms may have been substituted by an alkyl and/or alkoxy group, a halogen and/or a phenyl group, which last-mentioned in its turn may be substituted, too. The units with two carboxyl groups are preferably obtained from unsubstituted terephthalic acid and/or isophthalic acid.

Depending on the desired properties of the polymer composition, a polymer in the polymer composition may also contain an amine-containing unit, which can be obtained, inter alia, from substances known in the art, for instance p-amino-benzoic acid, p-aminophenol, p-N-methylaminophenol, p-phenylene-diamine, N-methyl-p-phenylenediamine, N,N′-dimethyl-p-phenylene-diamine, m-aminophenol, 4-amino-1-naphthol, 4-amino-4′-hydroxydi-phenyl, 4-amino-4′-hydroxyphenylether, 4-amino-4′-hydroxydiphenylmethane, 4-amino-4′-hydroxydiphenylethane, 4-amino-4′-hydroxydiphenylsulphone, 4-amino-4′-hydroxydiphenylsulphide, 4,4′-diaminophenylsulphide, 4,4′-diaminodiphenylsulphone, 2,5-diaminotoluene, 4,4′-ethylenephenyldiamine, 4,4′-diaminodi-phenoxyethane, 4,4′-diaminodiphenylmethane, 4,4′-diaminodiphenylether.

Preferably the polymer in the polymer composition consists of units having the formula Ia, IIb and from terephthalic and/or isophthalic acid, the polymer having an average pressure flow index (PFI) value of maximum 8.5 g/10 minutes. The PFI value is a measure for the processability and is measured at constant pressure using a rheometer. The PFI value is preferably 7.5 grammes/10 minutes at most.

The liquid-crystalline polymer is produced by reacting the monomers to be used at elevated temperature for some time, after acetylation with acetic anhydride. The polymerization reaction is performed between 150°C and 350°C in an inert atmosphere, for instance nitrogen, until a polycondensate with the

desired degree of polymerization is obtained. During the polymerization reaction the acetic acid formed and the excess of acetic anhydride are distilled off. The degree of polymerization can be determined by, for instance, deter mining the amount of terminal groups or from the amount of acetic acid resulting after distillation, adjusted for the amount of acetic acid released in the acetylation. It is possible, but not strictly necessary, for the condensation or esterification to be carried out in the presence of a catalyst, in the form of a salt, for instance lithium acetate, sodium acetate, potassium acetate, magnesium acetate, calcium benzoate, magnesium acetylacetonate, zinc acetyl-acetonate, zinc acetate, zinc butylate, zirconium propylate, dibutyl tin diacetate, sodium phenolate. The catalyst is added in amounts of up to 1% (wt) calculated on the total weight of the monomers used.

The package according to the invention is preferably made from a polymer composition comprising:

- 20-70% (wt) units obtained from parahydroxybenzoic acid,
- 5-50% (wt) units obtained from biphenol and/or hydroquinone,
- 5-50% (wt) units obtained from isophthalic and/or terephthalic acid, and
- 1-60% (wt) of one or more fillers.

The package according to the invention is preferably built up from a polymer composition containing 10-50% (wt) of one or more fillers. The filler is preferably chosen from the group of silica, α-quartz, alumina, carbon, fused silica, kaolin, talcum, wollastonite and/or combinations of these. More particularly the filler is silica, α-quartz, carbon, alumina and/or fused silica.

Packages according to the invention of which the encapsulating element is made from the above-mentioned polymer composition have a high temperature resistance and are therefore resistant against the high temperatures that occur in the usual soldering techniques.

The package according to the invention is preferably produced by means of injection moulding or tranfer moulding processes. More particularly by means of injection moulding.

The sealer is preferably made from the same liquid-crystalline polymer composition used also for the production of the encapsulating element of the package. It is possible, however, for the sealer to be made from a different material. Particularly suited for this purpose are silicone resin, metal or quartz.

The sealer can be applied to the package using a bonding system known per se. Preference is given to gluing and welding techniques. These techniques make it possible for the package to be hermetically sealed. Hermetic sealing results in an extended life of the integrated circuit.

The scope of the invention is an electronic component consisting of an integrated circuit applied to a carrier and encapsulated in an encapsulating element, which component is characterized in that the encapsulating element has been obtained from a liquid-crystalline polymer composition comprising:

- 20-70% (wt) units obtained from para-hydroxybenzoic acid,
- 5-50% (wt) units obtained from hydroquinone and/or biphenol,
- 5-50% (wt) obtained from isophthalic and/or terephthalic acid,
- 10-50% (wt) filler,

with the liquid-crystalline polymer in the polymer composition having a maximum PFI of 8.5 g/10 minutes, which liquid-crystalline polymer composition has been premoulded on a carrier to form an encapsulating element with an opening for taking up an integrated circuit, upon which the integrated circuit has been applied to the carrier in the encapsulating element and the opening has been sealed with a sealer.

The invention is particularly suited for packages for the so-called custom ICs.

Packages according to the invention are not confined to the embodiment described, but also include packages with openings on either side of the carrier for taking up one or more integrated circuits.

It is possible also to make a package having no carrier, which package just consists of an encapsulating element with conducting paths applied therein by means of plating or sputtering techniques.

The invention is further elucidated by means of the following examples without being limited thereto.

## Example I

Into a steel reaction vessel with stirrer, nitrogen feed tube and reflux condenser 8.5 kg acetic anhydride was introduced. To it were added:

32 moles p-hydroxybenzoic acid,
16 moles terephthalic acid,
16 moles p,p-biphenol, and
10 grammes zinc acetate.

The suspension was heated to 115¤C and kept at this temperature for 1-3 hours (refluxing). The temperature was subsequently raised by 46¤C/hour to 315¤C and kept at this temperature until the desired

conversion was reached (92%).

After cooling to room temperature, the polymer obtained was ground, subjected to after-condensation (12 hours, 350¤C) and characterized using a Differential Scanning Calorimeter (DSC).

The melting point was 401¤C. The average PFI value was 6.3 g/10 minutes, measured on a Göttfert 2000 rheometer. The settings of the rheometer were: T: 410¤C, pressure 100 bar.

The filler used was silica with the following characteristics:

- weight-average particle size: 13 µm,
- 90% (m/m) has a particle size < 30 µm,
- pore volume 0.5 $cm^3$ per g,
- specific surface 0.75 $m^2$ per g.

The silica was dispersed in the liquid-crystalline polymer as uniformly as possible. The silica content of the polymer was 50% (m/m). For the dispersion, a Werner & Pfleiderer contra-rotating twin screw extruder with a screw diameter of 30 mm was used. The polymer and the silica were metered into a first feed opening.

The cylinder temperature was set at 390¤C and the speed was 250 RPM. The compounded material was granulated using a Scheer granulator.

The flow behaviour of the polymer composition was measured by means of a spiral flow test on an Arburg Allrounder injection moulding machine (220-90-350) with a screw diameter of 22 mm. The length of the flow spiral was 40 cm.

The coefficient of linear expansion into the direction of flow was lower than 8 ppm/¤C and into the direction perpendicular thereto lower than 40 ppm/¤C.

Film gate mouldings (65 x 65 x 1.6 $mm^3$) made from the polymer composition were characterized for their flexural modulus (ASTM D790) and for their Izod (ISO 180, thickness 1.6 mm):

flexural modulus // : 18,800 $N/mm^2$;
flexural modulus, perp. : 2200 $N/mm^2$;
Izod // : 23 $KJ/m^2$;
Izod, perp. : 7 $KJ/m^2$.

From the polymer composition were produced encapsulating elements on a carrier, the carrier used being a 32-pin dual-in-line lead frame of an iron/nickle alloy. These lead frames were available in the form of strips with a length of 223.5 mm, a width of 49.2 mm and a thickness of 0.25 mm. Every strip contains 10 lead frames. The die pads on these lead frames were 13.6 mm long and 8.8 mm wide.

The encapsulating elements were produced by means of injection moulding. For this purpose an Arburg Allrounder injection moulding machine, type 220-90-350, was used.

The injection mould had two cavities, which were filled via a central feed. Each cavity was about 40.5 mm long, about 13.1 mm wide and about 4 mm thick.

The strip of lead frames was placed in the mould by means of guide pins so that the lead frames were maintained in their correct positions in the mould. In the cavities a draft angle of about 3¤ was provided. Further, in the mould, an elevation 17.5 mm long, 11.0 mm wide and 1.9 mm high is provided on the closing side in the middle of every cavity.

For the injection moulding of the encapsulating elements the processing conditions applied were as follows:

cylinder temperature: 390¤C
mould temperature : 150¤C
injection pressure : 960 bar
after-pressure : 480 bar
after-pressure time : 10 sec
cooling time : 10 sec
speed : 250 RPM

In the injection moulding process using the mould described above a package was formed consisting of a lead frame and an encapsulating element, which package was hermetically sealed on one side by a polymer composition described in this example.

The bonding of the encapsulating element to the carrier was excellent, there was no contamination of the carrier. The wires connecting the transistors with the connecting pins were not broken or bent.

## Example II

Into a steel reaction vessel with stirrer, nitrogen feed tube and reflux condenser 8.5 kg acetic anhydride

was introduced. To it was added:
32 moles p-hydroxybenzoic acid,
12 moles terephthalic acid,
8 moles p,p′-biphenol,
4 moles isophthalic acid,
8 moles hydroquinone, and
10 grammes zinc acetate.

The suspension was heated to 155¤C and kept at this temperature for 1-3 hours (refluxing).

The temperature was subsequently raised by 46¤C/hour to 250¤C and subsequently kept at this temperature until the desired conversion was reached.

After cooling to room temperature, the polymer obtained was ground, subjected to after-condensation (12 hours, 290¤C) and characterized using a Differential Scanning Calorimeter (DSC).

The melting point was 315¤C. The PFI value was 7.1 g/10 minutes (325¤C, 100 bar).

Using a solution of 0.1% (wt) polymer in pentafluorophenol at a temperature of 60¤C, the inherent viscosity (dl/g) of the polymer was determined according to the following formula:
I.V. = ln (rel)/c
where c = concentration of the solution (g per dl) and
rel = relative viscosity.

The I.V. value was 5.0 dl/g.

The filler used was Elmin El $44^R$ (fused silica) from C-E Minerals, Combustion Engineering Inc., U.S.A., having the following characteristics:
- weight-average particle size of about 9.5 µm,
- particle size for 99% (m/m) < 40 µm,
- bulk density 0.65 $g/cm^3$,
- specific surface 1.6 $m^2$ per g.

The silica was dispersed in the polymer composition as uniformly as possible. The silica content of the polymer was 50% (m/m). For the dispersion, a Werner & Pfleiderer contra-rotating twin screw extruder with a screw diameter of 30 mm was used. The polymer and the silica were metered into the first feed opening.

The cylinder temperature was set at 320¤C and the speed was 250 RPM. The compounded material was granulated using a Scheer granulator.

The coefficient of linear expansion into the direction of flow was lower than 8 ppm/¤C and into the direction perpendicular thereto lower than 40 ppm/¤C.

From the polymer composition were made encapsulating elements on a carrier, the carrier being a 40-pin Cu-PLCC lead frame (Plastic Leaded Chip Carrier) with a length of 221 mm, a width of 31 mm and a thickness of 0.25 mm. Each strip contained 8 lead frames (see figure 1). The die pads on these lead frames were 7.7 mm long and wide.

The encapsulating elements were produced by means of injection moulding. For this purpose an Arburg Allrounder injection moulding machine (220-90-350) was used.

The injection mould had two cavities, which were filled via a central feed. Each cavity was 16.3 mm long, 16.3 mm wide and 4 mm thick.

The strip with lead frames was placed in the mould by means of guide pins so that the lead frames were maintained in their correct positions in the mould. In the cavities a draft angle of about 3¤ had been provided. Further, in the mould, an elevation 10.7 mm long, 10.7 mm wide and about 1.9 mm high had been provided on the closing side in the middle of every cavity.

For the injection moulding of the encapsulating elements the following processing conditions were applied:
cylinder temperature: 330¤C
mould temperature : 150¤C
injection pressure : 960 bar
after-pressure : 480 bar
after-pressure time : 10 sec
cooling time : 10 sec
speed : 250 RPM

In the injection moulding process using the mould described above, encapsulating elements were obtained on a lead frame, the resulting package being hermetically covered on one side by the polymer composition described in this example.

The results of the package obtained were the same as those of the package of example I.

Comparative example A

Ditto as example I, but the polymer composition was subjected to after-condensation for 6 hours at 325¤C.

The melting temperature was 375¤C. The average PFI value (40¤C, 100 bar) was 9.7 g/10 minutes.

The characterization of the film gate mouldings resulted in a bending modulus of 6100 $N/mm^2$ parallel and 2200 $N/mm^2$ perpendicular. The mouldings were so brittle that the Izod could not be determined.

As a result, this polymer was unfit to be used for the production of packages.

## Claims

1. Package for an integrated circuit, consisting of a carrier and an encapsulating element, the encapsulating element being made from a liquid-crystalline polymer composition, characterized in that the encapsulating element consists of a liquid-crystalline polymer composition moulded round the carrier with an opening for taking up the integrated circuit, the liquid-crystalline polymer in the polymer composition having a maximum pressure-flow index (PFI) of 8.5 g/10 minutes.

2. Package according to claim 1, characterized in that the liquid-crystalline polymer composition is pre-moulded by means of injection moulding to form an encapsulating element.

3. Package according to any one of claims 1-2, characterized in that the liquid-crystalline polymer composition consists of:

- 20-70% (wt) units obtained from parahydroxybenzoic acid,
- 5-50% (wt) units obtained from biphenol and/or hydroquinone,
- 5-50% (wt) units obtained from terephthalic and/or isophthalic acid, and
- 1-60% (wt) of one or more fillers.

4. Package according to claim 3, characterized in that the polymer composition contains 10-50% (wt) fillers.

5. Package according to any one of claims 3-4, characterized in that the fillers are a combination of silica, quartz, alumina, fused silica and/or carbon.

6. Package according to any one of claims 3-5, characterized in that the liquid-crystalline polymer in the polymer composition has a maximum PFI value of 7.5 g/10 minutes.

7. Sealer for sealing an opening of a pre-moulded encapsulating element according to any one of claims 1-6, which sealer is made from a liquid-crystalline polymer composition.

8. Electronic component consisting of an integrated circuit applied to a carrier and surrounded by an encapsulating element, characterized in that the encapsulating element has been obtained from a liquid-crystalline polymer composition consisting of:

- 20-70% (wt) units obtained from parahydroxybenzoic acid,
- 5-50% (wt) units obtained from hydroquinone and/or biphenol,
- 5-50% (wt) units obtained from isophthalic and/or terephthalic acid, and
- 10-50% (wt) filler;

where the liquid-crystalline polymer in the polymer composition has a maximum PFI of 8.5 g/10 minutes, which liquid-crystalline polymer composition has been pre-moulded onto a carrier to form an encapsulating element with an opening for taking up an integrated circuit, whereupon an integrated circuit has been applied on the carrier in the encapsulating element and the opening has been sealed with a sealer.

FIG. 1

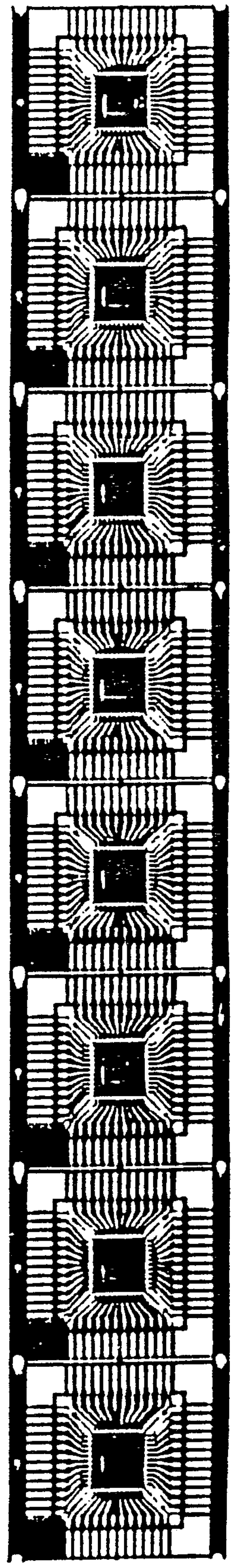

European Patent Office

# EUROPEAN SEARCH REPORT

Application Number

EP 90 20 1440

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A,D | EP-A-135310 (CELANESE CORP)<br>* abstract *<br>* page 28, lines 19 - 21 * | 1-8 | H01L23/29 |
| A | PATENT ABSTRACTS OF JAPAN<br>vol. 10, no. 283 (E-440)(2339) 26 September 1986,<br>& JP-A-61 102760 (MATSUSHITA) 21 May 1986,<br>* the whole document * | 1, 2, 8 | |
| A | DE-A-3625265 (BASF)<br>* the whole document * | 1-3, 8 | |
| A | PATENT ABSTRACTS OF JAPAN<br>vol. 13, no. 227 (C-600) 25 May 1989,<br>& JP-A-01 038432 (TORAY) 08 February 1989,<br>* the whole document * | 1, 3, 8 | |
| A | EP-A-305683 (HÜLS AKTIENGESELLSCHAFT)<br>* page 3, lines 49 - 57 * | 1-3, 8 | TECHNICAL FIELDS SEARCHED (Int. Cl.5 ) |
| A | EP-A-226839 (BASF)<br>* the whole document * | 3, 8 | H01L<br>C08G<br>C09K |

The present search report has been drawn up for all claims

| Place of search | Date of completion of the search | Examiner |
|---|---|---|
| THE HAGUE | 14 SEPTEMBER 1990 | DELPORTE B.P.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document



EPO FORM 1503 03.82 (P0401)